# EUROPEAN PATENT SPECIFICATION

(11) **EP 3 519 973 B1**
(45) Date of publication and mention of the grant of the patent: **01.12.2021**
(21) Application number: 17778423.8
(22) Date of filing: 21.09.2017
(51) Int. Cl.: G06F 12/0864, G06F 12/0895, G11C 15/04, G11C 15/00

(54) **AREA EFFICIENT ARCHITECTURE FOR MULTI WAY READ ON HIGHLY ASSOCIATIVE CONTENT ADDRESSABLE MEMORY (CAM) ARRAYS**
FLÄCHENEFFIZIENTE ARCHITEKTUR FÜR LESEN IN MEHREREN RICHTUNGEN AUF STARK ASSOZIATIVEN INHALTSADRESSIERBAREN SPEICHERARRAYS (CAM)
ARCHITECTURE EFFICIENTE PAR ZONES POUR LECTURE MULTIVOIES SUR RÉSEAUX DE MÉMOIRE ADRESSABLE PAR LE CONTENU (CAM) HAUTEMENT ASSOCIATIVE

(30) Priority: 29.09.2016 US 201662401614 P; 20.09.2017 US 201715710108
(43) Date of publication of application: 07.08.2019
(73) Proprietor: Qualcomm Incorporated, San Diego, CA 92121-1714 (US)
(72) Inventor: SHANKAR, Harish, San Diego California 92121-1714 (US); GARG, Manish, San Diego California 92121-1714 (US)
(74) Representative: Tomkins & Co
(86) International application number: PCT/US2017/052752
(87) International publication number: WO 2018/063916

(56) References cited:
- US-A- 6 131 143
- US-A1- 2012 210 056
- US-A1- 2013 007 358
- KWAK J W ET AL: "Compressed tag architecture for low-power embedded cache systems", JOURNAL OF SYSTEMS ARCHITECTURE, ELSEVIER BV, NL, vol. 56, no. 9, 1 September 2010 (2010-09-01), pages 419-428, XP027207235, ISSN: 1383-7621 [retrieved on 2010-08-10]
- MING YANG ET AL: "Tag compression for low power in instruction caches", 2007 IEEE CONFERENCE ON ELECTRON DEVICES AND SOLID-STATE CIRCUITS : [EDSSC 2007] ; TAINAN, TAIWAN, 20 - 22 DECEMBER 2007, IEEE SERVICE CENTER, PISCATAWAY, NJ, USA, 20 December 2007 (2007-12-20), pages 837-840, XP031229915, ISBN: 978-1-4244-0636-4
- HYUNSUN PARK ET AL: "A novel tag access scheme for low power L2 cache", DESIGN, AUTOMATION&TEST IN EUROPE CONFERENCE&EXHIBITION (DATE), 2011, IEEE, 14 March 2011 (2011-03-14), pages 1-6, XP032318198, DOI: 10.1109/DATE.2011.5763108 ISBN: 978-1-61284-208-0

## Description

### BACKGROUND

### Field of the Disclosure

Aspects disclosed herein relate to the field of memory architecture. More specifically, aspects disclosed herein relate to content addressable memories (CAMs).

### Description of Related Art

Content Addressable Memory (CAM) is a type of memory that enables high-speed parallel searching of the memory for a desired data word. As such, CAMs may be used in search-intensive applications.

In high performance CPU architectures, the cache hit rate is a significant contributor to the overall achievable instructions per cycle (IPC) of the architecture. Server CPU architectures typically have larger cache sizes and a greater associativity than other architectures. A cache typically consists of a tag array which stores the tag to be compared against and a data array that stores the data corresponding to the tag. In most high bus width applications (e.g., 64 bit or higher), the higher order tag bits rarely change and hence these bits are compressed before being stored tag array. During a tag search, these compressed bits from all ways may be read out from the tag array to be compared against an external lookup table.

Such compression typically adversely impacts power, performance, or area (PPA) of the tag array, however, and causes timing penalty as the compressed bits may need to be looked up before a tag search.

Therefore, techniques and architectures for improving performance of reading CAM structures may be provided.

KWAK J.W et al. disclose in the paper titled "Compressed tag architecture for low-power embedded cache systems" (ISSN: 1383-7621) a set-associative cache whose tags are compressed for implementing low-power embedded cache systems, whereby: a locality buffer holds the high order bits of the tags; an index of the locability buffer is used as compressed version of said high order bits; the high order and the low order bits of the tags are compared with the incoming tag, to generate a hit signal. US2013/007358 A1 discloses replicating tag entries for reliability enhancement in cache tag arrays. MING YANG et al. disclose in the paper titled "Tag compression for low power in instruction caches" tag compression in a low-power instruction-, set-associative cache (ISBN:978-1-4244-0636-4). US2012/210056 A1 discloses a cache memory and control method thereof. US 6 131 143 A discloses a multi-way associative storage type cache memory. HYUNSUN PARK et al. disclose in the paper titled "A novel tag access scheme for low power L2 cache" a tag access scheme for low power L2 cache (ISBN:978-1-61284-208-0).

### SUMMARY

Aspects disclosed herein provide techniques and an efficient architecture for enabling multi-way reads on highly associative CAM arrays. The present invention is defined in the appended independent claims to which reference should be made. Advantageous features are set out in the appended dependent claims.

In one aspect, a method for performing a tag search of a tag array is provided. The method generally includes reading a first subset of stored tag bits from multiple entries of the tag array and comparing a second subset of stored tag bits from a one or more entries of the tag array against a search-tag to produce one or more possible way hit signals.

In one aspect, a method for performing a tag search of a tag array is provided. The method generally includes reading a first subset of stored tag bits from at least one entry of the tag array and reading a second subset of stored bits from the at least one entry if a condition is met.

In one aspect, as claimed, a content addressable memory (CAM) structure is provided. The CAM structure generally includes a tag array, multi-way read logic for reading a first subset of stored tag bits from multiple entries of the tag array, and comparison logic for comparing a second subset of stored tag bits from a one or more entries of the tag array against a search-tag to produce one or more possible way hit signals.

In one aspect, a content addressable memory (CAM) structure is provided. The CAM structure generally includes a tag array, read logic for reading a first subset of stored tag bits from at least one entry of the tag array, and conditional read logic for reading a second subset of stored bits from the at least one entry if a condition is met.

### BRIEF DESCRIPTION OF THE DRAWINGS

So that the manner in which the above recited aspects are attained and can be understood in detail, a more particular description of aspects of the disclosure, briefly summarized above, may be had by reference to the appended drawings.

It is to be noted, however, that the appended drawings illustrate only aspects of this disclosure and are therefore not to be considered limiting of its scope, for the disclosure may admit to other aspects falling within the scope of the appended claims.
Figure 1 is a functional block diagram of an exemplary computing device configured to operate according to aspects of the present disclosure.
Figure 2 is a flow chart illustrating example operations for reading from multiple ways, according to aspects of the present disclosure.
Figure 3 illustrates an example static read port according to aspects of the present disclosure.
Figure 4 illustrates example logic for a conditional read of tag bits according to aspects of the present disclosure.
Figure 5 illustrates an example tag bank layout according to aspects of the present disclosure.
Figure 6 illustrates an exampleis a functional block diagram of an exemplary processor configured to execute instructions of an instruction set prepared by a process according to aspects of the present disclosure.
Figure 7 is a flow chart illustrating example operations for performing a tag search of a tag array, according to aspects of the present disclosure.

### DETAILED DESCRIPTION

Aspects disclosed herein provide techniques for reading from multiple ways from a tag array.

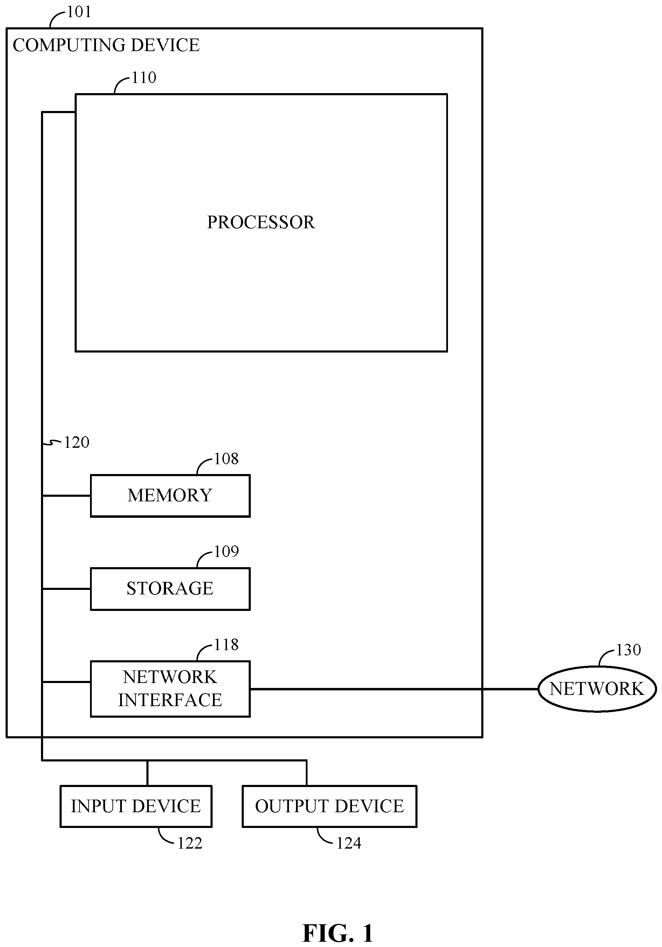

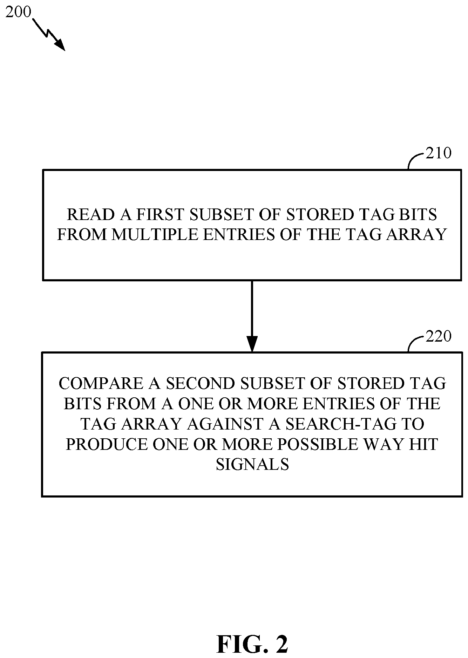

Figure 1 is a block diagram illustrating a computing device 101 that may include a memory structure configured to operate according to aspects of the present disclosure. For example, the computing device includes a memory 108 with a cache having a tag array searchable by performing operations 200, shown in Figure 2

The computing device 101 may also be connected to other computing devices via a network 130. In general, the network 130 may be a telecommunications network and/or a wide area network (WAN). In a particular aspect, the network 130 is the Internet. Generally, the computing device 101 may be any type of computing device configured to synthesize computer machine instructions, including, without limitation, a desktop computer, a server, a laptop computer, and a tablet computer.

The computing device 101 generally includes a processor 110 connected via a bus 120 to a memory 108, a network interface device 118, a storage 109, an input device 122, and an output device 124. The computing device 101 generally operates according to an operating system (not shown). Any operating system supporting the functions disclosed herein may be used. The processor 110 is included to be representative of a single processor, multiple processors, a single processor having multiple processing cores, and the like. The network interface device 118 may be any type of network communications device allowing the computing device 101 to communicate with other computing devices via the network 130.

The storage 109 may be a persistent storage device. Although the storage 109 is shown as a single unit, the storage 109 may be a combination of fixed and/or removable storage devices, such as fixed disc drives, solid state drives, SAN storage, NAS storage, removable memory cards or optical storage. The memory 108 and the storage 109 may be part of one virtual address space spanning multiple primary and secondary storage devices.

The input device 122 may be any device operable to enable a user to provide input to the computing device 101. For example, the input device 122 may be a keyboard and/or a mouse. The output device 124 may be any device operable to provide output to a user of the computing device 101. For example, the output device 124 may be any conventional display screen and/or set of speakers. Although shown separately from the input device 122, the output device 124 and input device 122 may be combined. For example, a display screen with an integrated touch-screen may be a combined input device 122 and output device 124.

As noted above, the memory 108 includes a cache structure. In some cases, the cache includes a tag array which stores the tag to be compared against and a data array that stores the data corresponding to the tag. In some applications, reading key bits from all WAYs, may present a challenge in CAM based tag arrays, because the bitlines are shared across tag entries from different ways. Having separate bitlines and associated peripheral circuitry would significantly degrade the array efficiency of the tag array.

Aspects of the present disclosure, as claimed, provide techniques and a corresponding architecture that allows for "multi-way" reading of a first set of tag bits from multiple rows, while reading a second set of tag bits from one or more single rows. In some cases, the first set of tag bits may be compressed bits (e.g., higher order address bits that are not likely to change often). As claimed, the reading of the first subset of stored tag bits is accomplished via a static read operation.

Figure 2 is a flow chart illustrating a method that includes operations 200 for reading a tag array that may be performed in a cache memory, for example, by logic within memory 108 shown in Figure 1, according to aspects of the present disclosure.

At block 210, the method begins by reading a first subset of stored tag bits from multiple entries of the tag array. At block 220, the method continues by performing a comparison of a second subset of stored tag bits from one or more entries of the tag array against a search-tag to produce one or more possible way hit signals. The hit signals may be considered possible because, even though these bits match, further resolution may be needed, for example, after decoding compressed bits. In accordance with one or more cases, a search-tag may be described as a tag portion of an address being accessed from a memory.

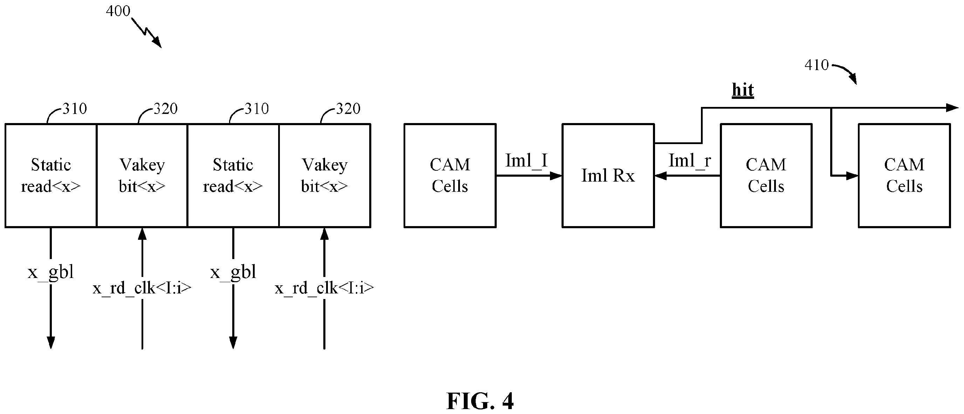

As claimed, tag compare logic is implemented using Content Addressable Memory (CAM) bitcells. Further, the match lines of the CAM bitcells may be combined in a match line receiver circuit, as shown in Figure 4, which generates a 'hit' signal which drives a global read word line, 'grwl', of the data array. In some cases, certain bits, such as permission and parity bits may be required only for the way that 'hits.' Hence, the output of the match line receiver may act as a read word line ('rwl') of these bits.

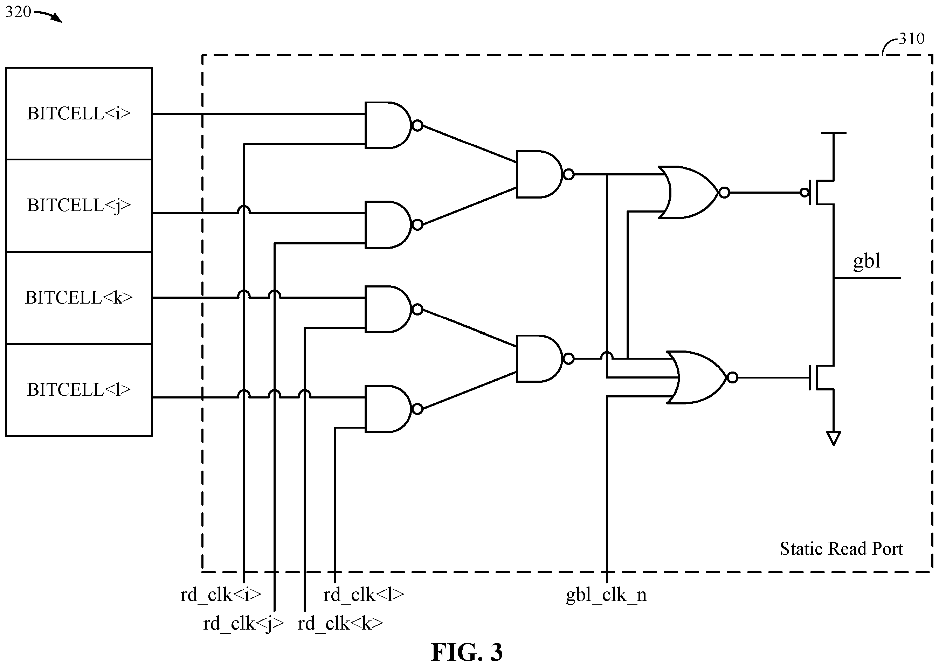

In some cases, compressed higher order bits (which may be referred to as virtual address key or VAKEY) may be read through a static read port stacked beside the bitcell in the tag row, as illustrated in Figure 3.

Figure 3 illustrates an example of such a static read port 310 that effectively multiplexes (muxes) the data bits from 4 adjacent bitcells 320 to a single global bitline (gbl) driver in the tag row. Integrating this 'gbl' driver into the tag row may help reduce the inclusion of duplicated peripheral circuits to read all ways from the array, which improves the array efficiency of the tag array. Further, because a static read option is used, the dynamic energy associated with the read of the VAKEY bits may be significantly reduced using this technique.

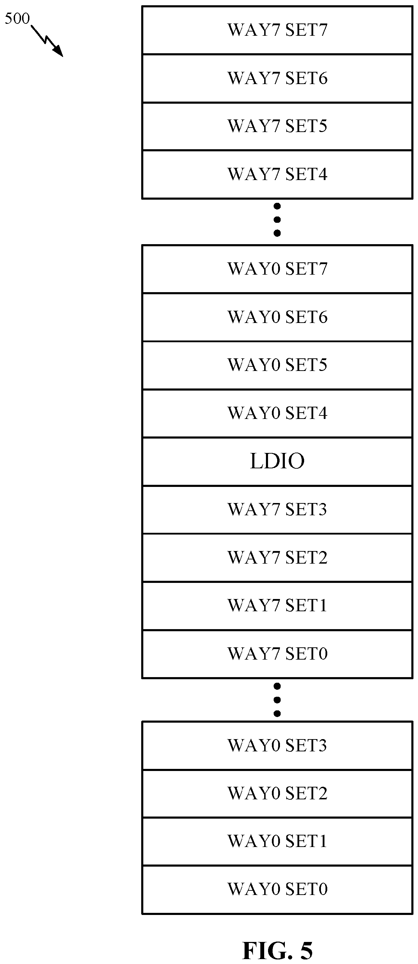

Figure 4 illustrates an example of an overall tag row floorplan 400 in accordance with certain aspects. In some cases, to mux the 4 bitcells 320 from adjacent rows into a single gbl driver via a static read port 310, it may be an objective that the 4 bitcells belong to the same WAY of different sets. Figure 5 illustrates an example bank structure 500 with such a floorplan to achieve this objective. In the example bank structure 500, different sets for the same way are arranged together. For example, starting at the bottom, way0 and sets 0-3 are arranged together, while moving to the top way 7 and sets 4-7 are arranged together.

Referring again to Figure 4, in some cases, other types of bits from certain cells 410 may be read out when certain conditions are met. For example, permission and parity bits may be read out during a tag search for a corresponding row that hits. Hence, the output of the match line receiver may act as a read word line ('rwl') for these bits. This may help conserve power by accessing such bits only when needed.

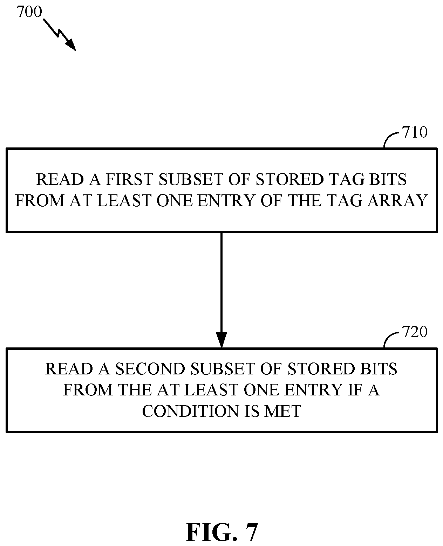

Figure 7 is a flow chart illustrating example operations 700 for performing a tag search of a tag array, according to aspects of the present disclosure. In one or more cases, the operations 700 for performing a tag search of a tag array as shown in figure 7 may include, as shown at block 710, reading a first subset of stored tag bits from at least one entry of the tag array. The operations 700 may also include, at block 720, reading a second subset of stored bits from the at least one entry only if a condition is met.

In some cases, the condition may include a tag hit for the at least one entry. Further, the second subset of stored bits may include at least one of permission bits or parity bits. A tag hit may be defined as the occurrence of when the value stored in the second subset of stored tag bits matches with an incoming address.

The architecture presented herein may result in significant area savings (e.g., of more than 10%) when compared with alternative techniques such as not compressing the higher order bits or using duplicated peripheral circuits in place of a static read port proposed herein. Such an architecture may be implemented in a memory structure which, in some cases, may be incorporated in a processor.

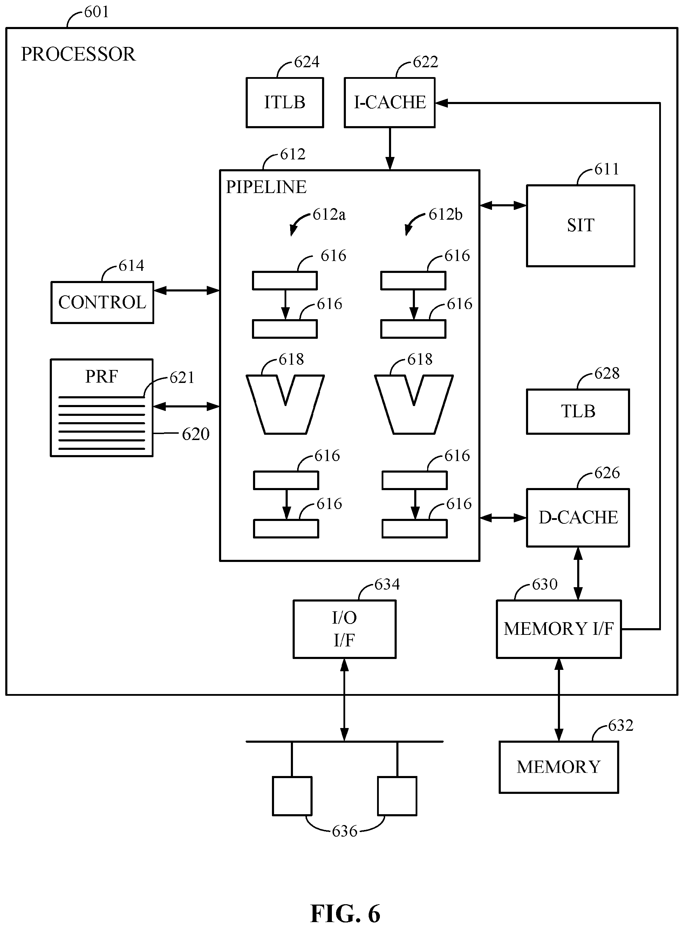

For example, Figure 6 is a functional block diagram of such an example processor (e.g., a CPU) 601 which may be configured with cache structures that operate according to aspects of the present disclosure. The processor 601 may be an example of the processor 110 shown in Figure 1. Generally, the processor 601 may be used in any type of computing device including, without limitation, a server, a desktop computer, a laptop computer, a tablet computer, and a smart phone. Generally, the processor 601 may include numerous variations, and the processor 601 shown in Figure 6 is for illustrative purposes and should not be considered limiting of the disclosure. For example, the processor 601 may be a graphics processing unit (GPU). In one aspect, the processor 601 is disposed on an integrated circuit including an instruction execution pipeline 612 and a storage instruction table (SIT) 611.

Generally, the processor 601 executes instructions in an instruction execution pipeline 612 according to control logic 614. The control logic 614 may be an embodiment of an instruction set architecture comprising an instruction set prepared by the process described in Figure 2, according to aspects of the present disclosure. The pipeline 612 may be a superscalar design, with multiple parallel pipelines, including, without limitation, parallel pipelines 612a and 612b. The pipelines 612a, 612b include various non-architected registers (or latches) 616, organized in pipe stages, and one or more arithmetic logic units (ALU) 618. A physical register file 620 includes a plurality of architected registers 621.

The pipelines 612a, 612b may fetch instructions from an instruction cache (I-Cache) 622, while an instruction-side translation lookaside buffer (ITLB) 624 may manage memory addressing and permissions. Data may be accessed from a data cache (D-cache) 626, while a main translation lookaside buffer (TLB) 628 may manage memory addressing and permissions. In some aspects, the ITLB 624 may be a copy of a part of the TLB 628. In other aspects, the ITLB 624 and the TLB 628 may be integrated. Similarly, in some aspects, the I-cache 622 and D-cache 626 may be integrated, or unified. Misses in the I-cache 622 and/or the D-cache 626 may cause an access to higher level caches (such as L2 or L3 cache) or main (off-chip) memory 632, which is under the control of a memory interface 630. The processor 601 may include an input/output interface (I/O IF) 634 that may control access to various peripheral devices 636.

A number of aspects have been described. However, various modifications to these aspects are possible, and the principles presented herein may be applied to other aspects as well. The various tasks of such methods may be implemented as sets of instructions executable by one or more arrays of logic elements, such as microprocessors, embedded controllers, or IP cores.

The foregoing disclosed devices and functionalities may be designed and configured into computer files (e.g. RTL, GDSII, GERBER, etc.) stored on computer readable media. Some or all such files may be provided to fabrication handlers who fabricate devices based on such files. Resulting products include semiconductor wafers that are then cut into semiconductor die and packaged into a semiconductor chip. Some or all such files may be provided to fabrication handlers who configure fabrication equipment using the design data to fabricate the devices described herein. Resulting products formed from the computer files include semiconductor wafers that are then cut into semiconductor die (e.g., the processor 101) and packaged, and may be further integrated into products including, but not limited to, mobile phones, smart phones, laptops, netbooks, tablets, ultrabooks, desktop computers, digital video recorders, settop boxes, servers, and any other devices where integrated circuits are used.

In one aspect, the computer files form a design structure including the circuits described above and shown in the Figures in the form of physical design layouts, schematics, a hardware-description language (e.g., Verilog, VHDL, etc.). For example, design structure may be a text file or a graphical representation of a circuit as described above and shown in the Figures. Design process preferably synthesizes (or translates) the circuits described below into a netlist, where the netlist is, for example, a list of wires, transistors, logic gates, control circuits, I/O, models, etc. that describes the connections to other elements and circuits in an integrated circuit design and recorded on at least one of machine readable medium. For example, the medium may be a storage medium such as a CD, a compact flash, other flash memory, or a harddisk drive. In another embodiment, the hardware, circuitry, and method described herein may be configured into computer files that simulate the function of the circuits described above and shown in the Figures when executed by a processor. These computer files may be used in circuitry simulation tools, schematic editors, or other software applications.

As used herein, a phrase referring to "at least one of' a list of items refers to any combination of those items, including single members. As an example, "at least one of: *a, b,* or *c*" is intended to cover *a, b, c, a-b, a-c, b-c,* and *a-b-c,* as well as any combination with multiples of the same element (e.g., *a-a, a-a-a, a-a-b, a-a-c, a-b-b, a-c-c, b-b, b-b-b, b-b-c, c-c,* and *c-c-c* or any other ordering of *a, b,* and *c).*

The previous description of the disclosed aspects is provided to enable a person skilled in the art to make or use the disclosed aspects. Various modifications to these aspects will be readily apparent to those skilled in the art, and the principles defined herein may be applied to other aspects without departing from the scope of the appended claims. Thus, the present disclosure is not intended to be limited to the aspects shown herein but is to be accorded the widest scope possible consistent with the principles and novel features as defined by the following claims.

## Claims

1. A method for performing a tag search of a tag array of a cache memory (108), said tag array comprising content addressable memory, CAM, bitcells, (320, 400), the method comprising:
reading a first subset of stored tag bits from multiple physical rows in a same bank of the tag array through a static read operation, while reading a second subset of stored tag bits from one or more single rows of the tag array; and
comparing the second subset of stored tag bits against a search-tag to produce one or more possible way hit signals; wherein the comparing of the second subset of stored tag bits is performed via a CAM port.

2. The method of claim 1, wherein the first subset of stored tag bits comprise bits that are compressed before being stored in the tag array.

3. The method of claim 1, wherein the first subset of stored tag bits comprise higher order address bits that are compressed before being stored in the tag array.

4. The method of claim 1, wherein:
the reading of the first subset of stored tag bits is accomplished via a static read operation.

5. The method of claim 1, further comprising:
reading a third subset of stored bits from a single physical row if a condition is met.

6. The method of claim 5, wherein the condition comprises a tag hit for the single physical row.

7. The method of claim 6, wherein the third subset of stored bits comprise at least one of permission bits or parity bits.

8. A content addressable memory, CAM, structure connectable to a cache memory (108) for performing a tag search in a tag array of the cache memory, said tag array comprising CAM bitcells (320, 400), the CAM structure comprising:
the tag array;
multi-way read logic for reading a first subset of stored tag bits from multiple physical rows in a same bank of the tag array through a static read operation, while reading a second subset of stored tag bits from one or more single rows of the tag array;
read logic for reading a second subset of stored tag bits from one or more single rows of the tag array; and
comparison logic for comparing the second subset of stored tag bits against a search-tag to produce one or more possible way hit signals; wherein the comparison logic comprises a CAM port.

9. The CAM structure of claim 8, wherein the first subset of stored tag bits comprise bits that are compressed before being stored in the tag array.

10. The CAM structure of claim 8, wherein the first subset of stored tag bits comprise higher order address bits that are compressed before being stored in the tag array.

11. The CAM structure of claim 8, wherein: the multi-way read logic is comprised of a static read port with adjacent CAM bit cells from different physical rows.

12. The CAM structure of claim 8, wherein:
the tag array is arranged in banks; and
each bank is arranged as physical rows, each physical row in a bank corresponding to a common way and a different set.

13. The CAM structure of claim 8, further comprising:
conditional read logic for reading a third subset of stored bits from a single physical row if a condition is met.

14. The CAM structure of claim 8, wherein the condition comprises a tag hit for the single physical row.

15. The CAM structure of claim 8, wherein the third subset of stored bits comprise at least one of permission bits or parity bits.

## Patentansprüche

1. Ein Verfahren zum Durchführen einer Kennzeichnungs- bzw. Tag-Suche einer Tag-Anordnung bzw. eines Tag-Arrays in einem Cache-Speicher (108), wobei der Tag-Array Bitzellen eines inhaltsadressierbaren Speichers bzw. CAM-Bitzellen (CAM = content addressable memory) (320, 400) aufweist, wobei das Verfahren Folgendes aufweist:
Lesen eines ersten Subsatzes von gespeicherten Tag-Bits aus mehreren physischen Zeilen in einer gleichen Bank des Tag-Arrays durch eine statische Leseoperation, während Lesen eines zweiten Subsatzes von gespeicherten Tag-Bits aus einer oder mehreren einzelnen Zeilen des Tag-Arrays; und
Vergleichen des zweiten Subsatzes von gespeicherten Tag-Bits mit einem Such-Tag zum Erzeugen von einem oder mehreren möglichen Pfadtreffersignalen; wobei das Vergleichen des zweiten Subsatzes von gespeicherten Tag-Bits über einen CAM-Port durchgeführt wird.

2. Verfahren nach Anspruch 1, wobei der erste Subsatz von gespeicherten Tag-Bits Bits aufweist, die komprimiert werden, bevor sie in dem Tag-Array gespeichert werden.

3. Verfahren nach Anspruch 1, wobei der erste Subsatz von gespeicherten Tag-Bits Adressbits einer höheren Ordnung aufweist, die komprimiert werden, bevor sie in dem Tag-Array gespeichert werden.

4. Verfahren nach Anspruch 1, wobei:
das Lesen des ersten Subsatzes von gespeicherten Tag-Bits über eine statische Leseoperation erreicht wird.

5. Verfahren nach Anspruch 1, das weiter Folgendes aufweist:
Lesen eines dritten Subsatzes von gespeicherten Bits aus einer einzelnen physischen Zeile, wenn eine Bedingung erfüllt wird.

6. Verfahren nach Anspruch 5, wobei die Bedingung einen Tag-Treffer für die einzelne physische Zeile aufweist.

7. Verfahren nach Anspruch 6, wobei der dritte Subsatz von gespeicherten Bits wenigstens eines von Erlaubnisbits oder Paritätsbits aufweist.

8. Eine Struktur eines inhaltsadressierbaren Speichers bzw. CAM-Struktur (CAM = content addressable memory), die mit einem Cache-Speicher (108) verbindbar ist zum Durchführen einer Kennzeichen- bzw. Tag-Suche in einer Tag-Anordnung bzw. einem Tag-Array des Cache-Speichers, wobei die Tag-Anordnung CAM-Bitzellen (320, 400) aufweist, wobei die CAM-Struktur Folgendes aufweist:
das Tag-Array;
Multi-Pfad-Leselogik zum Lesen eines ersten Subsatzes von gespeicherten Tag-Bits aus mehreren physischen Zeilen in einer gleichen Bank des Tag-Arrays durch eine statische Leseoperation, während Lesen eines zweiten Subsatzes von gespeicherten Tag-Bits aus einer oder mehreren einzelnen Zeilen des Tag-Arrays;
Leselogik zum Lesen eines zweiten Subsatzes von gespeicherten Tag-Bits aus einer oder mehreren einzelnen Zeilen des Tag-Arrays; und
Vergleichslogik zum Vergleichen des zweiten Subsatzes von gespeicherten Tag-Bits mit einem Such-Tag zum Erzeugen von einem oder mehreren möglichen Pfadtreffersignalen; wobei die Vergleichslogik einen CAM-Port aufweist.

9. CAM-Struktur nach Anspruch 8, wobei der erste Subsatz von gespeicherten Tag-Bits Bits aufweist, die komprimiert werden, bevor sie in der Tag-Anordnung gespeichert werden.

10. CAM-Struktur nach Anspruch 8, wobei der erste Subsatz von gespeicherten Tag-Bits Adressbits höherer Ordnung aufweist, die komprimiert werden, bevor sie in der Tag-Anordnung gespeichert werden.

11. CAM-Struktur nach Anspruch 8, wobei die Multi-Wege-Leselogik aus einem statischen Lese-Port mit angrenzenden CAM-Bitzellen aus unterschiedlichen physischen Zeilen besteht.

12. CAM-Struktur nach Anspruch 8, wobei:
das Tag-Array in Bänken angeordnet ist; und
jede Bank in einer physischen Zeile angeordnet ist, wobei jede physische Zeile in einer Bank einem gemeinsamen Pfad und einem unterschiedlichen Satz entspricht.

13. CAM-Struktur nach Anspruch 8, die weiter Folgendes aufweist:
konditionale bzw. bedingte Leselogik zum Lesen eines dritten Subsatzes von gespeicherten Bits aus einer einzelnen physischen Zeile, wenn eine Bedingung erfüllt ist.

14. CAM-Struktur nach Anspruch 8, wobei die Bedingung einen Tag-Treffer für die einzelne physische Zeile aufweist.

15. CAM-Struktur nach Anspruch 8, wobei der dritte Subsatz von gespeicherten Bits wenigstens eines von Erlaubnisbits oder Paritätsbits aufweist.

## Revendications

1. Un procédé pour effectuer une recherche d'étiquette d'un tableau d'étiquettes de mémoire cache (108), ledit tableau d'étiquettes comprenant des cellules binaires (320, 400) d'une mémoire adressable par le contenu (CAM), le procédé comprenant :
la lecture d'un premier sous-ensemble de bits d'étiquette stockés à partir de plusieurs rangées physiques dans un même banc du tableau d'étiquettes par le biais d'une opération de lecture statique, tout en lisant un deuxième sous-ensemble de bits d'étiquette stockés à partir d'une ou plusieurs rangées simples du tableau d'étiquettes; et
la comparaison du deuxième sous-ensemble de bits d'étiquette stockés à une étiquette de recherche pour produire un ou plusieurs signaux de voie trouvée possibles ; dans lequel la comparaison du deuxième sous-ensemble de bits d'étiquette stockés est effectuée via un port de la CAM

2. Le procédé selon la revendication 1, dans lequel le premier sous-ensemble de bits d'étiquette stockés comprend des bits qui sont compressés avant d'être stockés dans le tableau d'étiquettes.

3. Le procédé selon la revendication 1, dans lequel le premier sous-ensemble de bits d'étiquette stockés comprend des bits d'adresse d'ordre supérieur qui sont compressés avant d'être stockés dans le tableau d'étiquettes.

4. Le procédé selon la revendication 1, dans lequel :
la lecture du premier sous-ensemble de bits d'étiquette stockés est effectuée via une opération de lecture statique.

5. Le procédé selon la revendication 1, comprenant en outre :
la lecture d'un troisième sous-ensemble de bits stockés à partir d'une seule rangée physique si une condition est remplie.

6. Le procédé selon la revendication 5, dans lequel la condition comprend une étiquette trouvée pour la seule rangée physique.

7. Le procédé selon la revendication 6, dans lequel le troisième sous-ensemble de bits stockées comprend au moins un parmi des bits de permission ou des bits de parité.

8. Structure de mémoire adressable par contenu, CAM, connectable à une mémoire cache (108) pour effectuer une recherche d'étiquette dans un tableau d'étiquettes de la mémoire cache, ledit tableau d'étiquettes comprenant des cellules binaires (320, 400) de la CAM, la structure de la CAM comprenant :
le tableau d'étiquettes ;
une logique de lecture multivoie pour lire un premier sous-ensemble de bits d'étiquette stockés à partir de plusieurs rangées physiques dans un même banc du tableau d'étiquettes par le biais d'une opération de lecture statique, tout en lisant un deuxième sous-ensemble de bits d'étiquette stockés à partir d'une ou plusieurs rangées simples du tableau d'étiquettes;
une logique de lecture pour lire un deuxième sous-ensemble de bits d'étiquette stockés à partir d'une ou plusieurs rangées simples du tableau d'étiquettes ; et
une logique de comparaison pour comparer le deuxième sous-ensemble de bits d'étiquette stockés à une étiquette de recherche pour produire un ou plusieurs signaux de voie trouvée possibles ; dans lequel la logique de comparaison comprend un port de la CAM

9. Structure de la CAM selon la revendication 8, dans laquelle le premier sous-ensemble de bits d'étiquette stockés comprend des bits qui sont compressés avant d'être stockés dans le tableau d'étiquettes.

10. Structure de la CAM selon la revendication 8, dans laquelle le premier sous-ensemble de bits d'étiquette stockés comprend des bits d'adresse d'ordre supérieur qui sont compressés avant d'être stockés dans le tableau d'étiquettes.

11. Structure de la CAM selon la revendication 8, dans laquelle : la logique de lecture multivoie comprend un port de lecture statique avec des cellules binaires de la CAM adjacentes provenant de différentes rangées physiques.

12. Structure de la CAM selon la revendication 8, dans laquelle :
le tableau d'étiquettes est disposé en bancs ; et
chaque banc est agencé en rangées physiques, chaque rangée physique dans une banc correspondant à une voie commune et à un ensemble différent.

13. Structure de la CAM selon la revendication 8, comprenant en outre :
une logique de lecture conditionnelle pour lire un troisième sous-ensemble de bits stockés à partir d'une seule rangée physique si une condition est remplie.

14. Structure de la CAM selon la revendication 8, dans laquelle la condition comprend une étiquette trouvée pour la seule rangée physique.

15. Structure de la CAM selon la revendication 8, dans laquelle le troisième sous-ensemble de bits stockés comprend au moins l'un parmi des bits de permission ou des bits de parité.
